# EUROPEAN PATENT SPECIFICATION

(11) **EP 3 493 401 B1**
(45) Date of publication and mention of the grant of the patent: **30.06.2021**
(21) Application number: 17205223.5
(22) Date of filing: 04.12.2017
(51) Int. Cl.: H03F 3/195

(54) **RADIO FREQUENCY AMPLIFIER AND INTEGRATED CIRCUIT USING THE RADIO FREQUENCY AMPLIFIER**
FUNKFREQUENZVERSTÄRKER UND INTEGRIERTE SCHALTUNG MIT DEM FUNKFREQUENZVERSTÄRKER
AMPLIFICATEUR DE FRÉQUENCE RADIO ET CIRCUIT INTÉGRÉ FAISANT APPEL À L'AMPLIFICATEUR DE FRÉQUENCE RADIO

(43) Date of publication of application: 05.06.2019
(73) Proprietor: National Chung Shan Institute of Science and Technology, Taoyuan City 325 (TW)
(72) Inventor: Liang, Chia-Jen, 807 Kaohsiung City (TW); Kuan, Yen-Cheng, 802 Kaohsiung City (TW); Chiang, Ching-Wen, 600 Chiayi City (TW); Chou, Hung-Ting, 242 New Taipei City (TW)
(74) Representative: Perani & Partners S.p.A.

(56) References cited:
- EP-A1- 3 171 513
- US-A1- 2011 148 527
- US-A1- 2016 336 983

## Description

### TECHNICAL FIELD

The present disclosure relates to a radio frequency amplifier and, more particularly, to a radio frequency amplifier which can be formed on an integrated circuit.

### BACKGROUND

An integrated circuit usually use a conventional radio frequency cascode amplifier as an input or output stage of the integrated circuit. However, the noise figure becomes severe as the gain improved by the conventional radio frequency cascode amplifier.

If the integrated circuit uses an amplifier, without a cascode circuit, as an input or output stage of the integrated circuit, then a gain efficiency of the amplifier may not meet the requirement. Therefore, it may be a difficult decision to make tradeoff between the gain efficiency and the noise figure when determining to use or not to use a cascode amplifier.

Further, a conventional radio frequency amplifier, with or without a cascode circuit, may not be fit in a multiband or wideband device because of the operating frequency of the conventional radio frequency amplifier is limited in a narrow range and not adjustable.

Accordingly, it is imperative to provide a radio frequency amplifier and an integrated circuit using the radio frequency amplifier which can overcome the aforesaid drawbacks of the conventional radio frequency amplifiers. Examples of known circuits are disclosed in documents US 2016/336983A1, EP 3171513A1 and US 20111485227A1.

### SUMMARY

In view of the aforesaid drawbacks of the prior art, it is an objective of the present disclosure to provide a radio frequency amplifier and an integrated circuit using the radio frequency amplifier which can have a wide and adjustable operating frequency and a better gain efficiency with no or fewer noise issues.

In order to achieve the above and other objectives, the present disclosure provides a radio frequency amplifier. The radio frequency amplifier comprises a transistor, a transformer and a variable capacitor. The transistor has an input terminal, an output terminal and a control terminal. The transformer has a first coil conductor and a second coil conductor. The first coil conductor magnetically couples to the second coil conductor. The second coil conductor connects to the control terminal. The first coil conductor connects to the input terminal. The variable capacitor connects in parallel with the second coil conductor.

Regarding the radio frequency amplifier, the radio frequency amplifier further comprises a signal input end and a signal output end, wherein the signal input end connects to the input terminal of the transistor and the signal output end connects to the output terminal of the transistor.

Regarding the radio frequency amplifier, the radio frequency amplifier further comprises an inductor connected between the signal input end and the input terminal of the transistor.

Regarding the radio frequency amplifier, the radio frequency amplifier further comprises a pad capacitor connected to the signal input end.

Regarding the radio frequency amplifier, the radio frequency amplifier further comprises a bypass capacitor connected to the second coil conductor.

In order to achieve the above and other objectives, the present disclosure provides an integrated circuit. The integrated circuit comprises a signal process circuit and a radio frequency amplifier. The radio frequency amplifier is configured to connect to the signal process circuit. The radio frequency amplifier includes a transistor, a transformer and a variable capacitor. The transistor has an input terminal, an output terminal and a control terminal. The transformer has a first coil conductor and a second coil conductor. The first coil conductor magnetically couples to the second coil conductor. The second coil conductor connects to the control terminal. The first coil conductor connects to the input terminal. The variable capacitor connects in parallel with the second coil conductor.

Regarding the integrated circuit, the radio frequency amplifier further includes a signal input end and a signal output end, wherein the signal input end connects to the input terminal of the transistor, the signal output end connects to the output terminal of the transistor and an input end of the signal process circuit connecting to the signal output end of the radio frequency amplifier.

Regarding the integrated circuit, the radio frequency amplifier further includes an inductor connected between the signal input end and the input terminal of the transistor.

Regarding the integrated circuit, the radio frequency amplifier further includes a pad capacitor connected to the signal input end.

Regarding the integrated circuit, the radio frequency amplifier further includes a bypass capacitor connected to the second coil conductor.

Regarding the integrated circuit, the radio frequency amplifier is configured to be an input or output stage of the integrated circuit.

In conclusion, give the aforesaid radio frequency amplifier and integrated circuit, the present disclosure feature a wide and adjustable operating frequency and a better gain efficiency with no or fewer noise issues.

### BRIEF DESCRIPTION OF THE DRAWINGS

Objectives, features, and advantages of the present disclosure are hereunder illustrated with specific embodiments in conjunction with the accompanying drawings.
FIG. 1 shows a detailed circuit of a radio frequency amplifier according to an embodiment of the present disclosure.
FIG. 2 shows a simulation result of a radio frequency amplifier according to an embodiment of the present disclosure.
FIG. 3 shows another one simulation result of a radio frequency amplifier according to an embodiment of the present disclosure.
FIG. 4 is a schematic diagram of an integrated circuit according to an embodiment of the present disclosure.

### DETAILED DESCRIPTION OF THE PREFERRED EMBODIMENTS

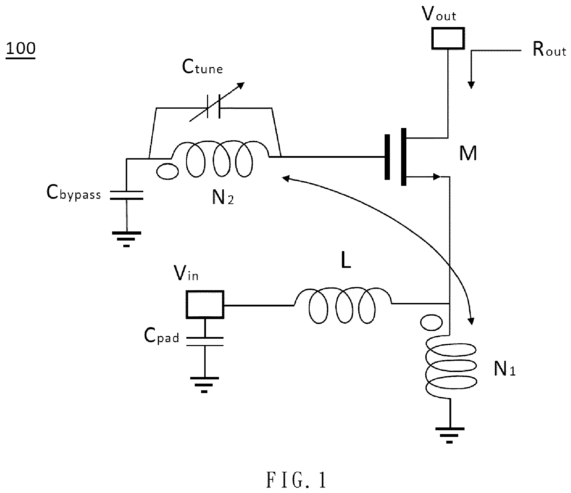

Referring to FIG. 1, FIG. 1 shows a detailed circuit of a radio frequency amplifier according to an embodiment of the present disclosure.

In FIG. 1, the radio frequency amplifier 100 comprises a transistor M, a transformer (formed by the first coil conductor N1 and the second coil conductor N2) and a variable capacitor Cₜᵤₙₑ. The transformer comprises a first coil conductor N1 and a second coil conductor N2. The first coil conductor N1 and the second coil conductor N2 magnetically couple to each other to form a transformer structure.

The transistor M has an input terminal, an output terminal and a control terminal. In this embodiment, the transistor M is a MOS transistor and has a source (input terminal), a drain (output terminal) and a gate (control terminal). The output impedance Rₒᵤₜ of the transistor M is determined by a view from the drain of the transistor M.

The capacitance value of the variable capacitor Cₜᵤₙₑ is adjustable. As the capacitance value of the variable capacitor Cₜᵤₙₑ is adjusted, the magnetic flux pass through the first coil conductor N1 is changed, and thus a current value pass through the second coil conductor N2 is changed because of coupling effect.

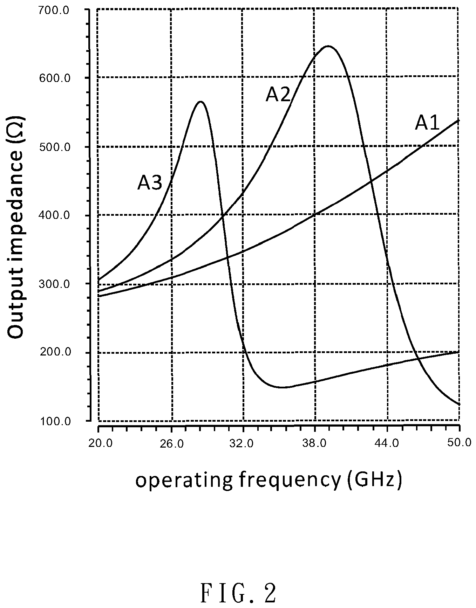

As shown as FIG. 2, The output impedance Rₒᵤₜ of curve A3 is significant more than the output impedance Rₒᵤₜ of curve A1 when the operating frequency near 28GHz. The output impedance Rₒᵤₜ of curve A2 is significant more than the output impedance Rₒᵤₜ of curve A1 when the operating frequency near 38GHz. The curve A1 is a simulation result given that the variable capacitor Cₜᵤₙₑ is not used. The curve A2 and A3 are a simulation results given that the variable capacitance Cₜᵤₙₑ is used. Obviously, the usage and adjustment of the variable capacitance Cₜᵤₙₑ improve the output impedance Rₒᵤₜ of the radio frequency amplifier 100 at a certain operating frequency.

As the output impedance Rₒᵤₜ of the radio frequency amplifier 100 increases at the certain operating frequency, the anti-noise ability of the radio frequency amplifier 100 improves. Furthermore, the certain operating frequency corresponding to the maximum output impedance Rₒᵤₜ can be tuned by adjusting the capacitance of the variable capacitance Cₜᵤₙₑ, and thus the radio frequency amplifier 100 can fit in a multiband or wideband device, for example, a radio transceiver. The operator can adjust the variable capacitor Cₜᵤₙₑ until a curve of the output impedance Rₒᵤₜ is optimized, for instance, maximizing the output impedance Rₒᵤₜ at the desired operating frequency range.

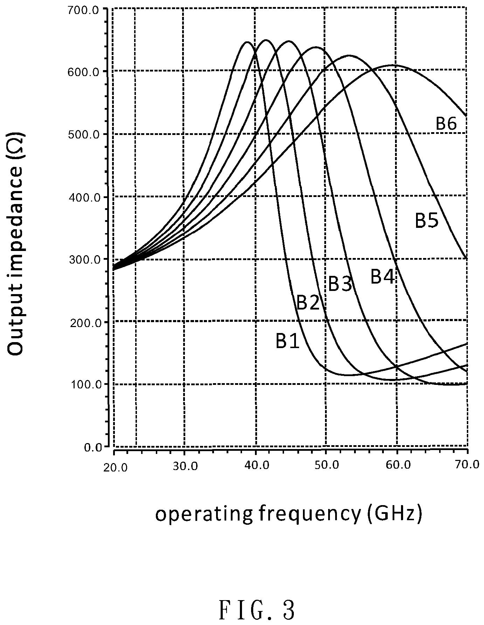

FIG. 3 shows another one simulation result of a radio frequency amplifier according to an embodiment of the present disclosure. In FIG. 3, the value of the output impedance Rₒᵤₜ of curves B1-B6 is maximized at different operating frequencies.

The value of the output impedance Rₒᵤₜ of curves B1 is maximized when the operating frequency is approximate to 38GHz. The value of the output impedance Rₒᵤₜ of curves B2 is maximized when the operating frequency is approximate to 42GHz. The value of the output impedance Rₒᵤₜ of curves B3 is maximized when the operating frequency is approximate to 44GHz. The value of the output impedance Rₒᵤₜ of curves B4 is maximized when the operating frequency is approximate to 48GHz. The value of the output impedance Rₒᵤₜ of curves B5 is maximized when the operating frequency is approximate to 53GHz. The value of the output impedance Rₒᵤₜ of curves B6 is maximized when the operating frequency is approximate to 59GHz. FIG. 3 further proves that the radio frequency amplifier 100 can fit in a multiband or wideband device.

Referring back to FIG. 1, the radio frequency amplifier 100 further comprises (but can be modified, eliminated or substituted in other embodiment) a signal input end Vᵢₙ, a signal output end Vₒᵤₜ, an inductor L, a pad capacitance C_{pad} and a bypass capacitance C_{bypass}.

The signal input end Vᵢₙ connects to the source (input terminal) of the transistor M. The signal output end Vₒᵤₜ connects to the drain (output terminal) of the transistor M. The inductor L connects between the signal input end Vᵢₙ and the source (input terminal) of the transistor M. The pad capacitance C_{pad} connected to the signal input end Vᵢₙ. The bypass capacitance C_{bypass} connected to the second coil conductor N2.

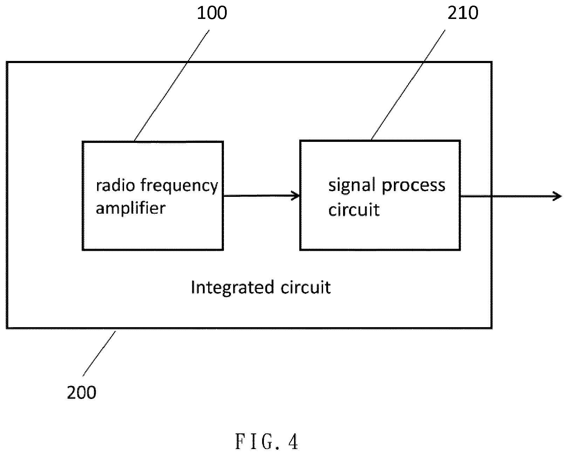

Referring to FIG. 4, FIG. 4 is a schematic diagram of an integrated circuit according to an embodiment of the present disclosure.

In FIG. 4, the radio frequency amplifier 100 is formed on an integrated circuit 200. The integrated circuit 200 further comprises a signal process circuit 210. The input end of the signal process circuit 210 connects to the signal output end Vₒᵤₜ of the integrated circuit 200. Therefore, after being processed by radio frequency amplifier 100, a processed signal as an input signal is transmitted to the signal process circuit 210. The radio frequency amplifier 100 can amplified the input signal before the signal input to the signal process circuit 210.

The radio frequency amplifier 100, which can be implemented without using a cascode circuit, can be configured to act as an input or output stage of the integrated circuit 200 (as an input stage in FIG.4) . Therefore, the radio frequency amplifier 100 can overcome the drawbacks of the conventional radio frequency cascode amplifiers. For example, the radio frequency amplifier 100 has no noise issue or fewer noise issues than the conventional radio frequency cascode amplifiers. The radio frequency amplifier 100 can also overcome the drawbacks of conventional radio frequency amplifiers without using a cascode circuit. For example, the radio frequency amplifier 100 has a better gain efficiency than the conventional radio frequency amplifiers without using a cascode circuit.

In conclusion, giving the aforesaid radio frequency amplifier and integrated circuit, the present disclosure features a wide and adjustable operating frequency and a better gain efficiency with no or fewer noise issues.

The present disclosure is disclosed above by preferred embodiments. However, persons skilled in the art should understand that the preferred embodiments are illustrative of the present disclosure only, but should not be interpreted as restrictive of the scope of the present disclosure. Accordingly, the legal protection for the present disclosure should be defined by the appended claims.

## Claims

1. A radio frequency amplifier comprising:
a transistor (M) having a source, a drain and a gate;
a transformer having a first coil conductor (N1) and a second coil conductor (N2), the first coil conductor (N1) magnetically coupling to the second coil conductor (N2), the second coil conductor (N2) is directly connected to the gate of the transistor (M), the first coil conductor (N1) is directly connected to the source of the transistor (M);
a variable capacitor (Cₜᵤₙₑ) connected in parallel with the second coil conductor (N2), and connected to the gate of the transistor (M);
a signal input end (Vᵢₙ); and
a signal output end (Vout),
wherein the signal input end (Vᵢₙ) connects to the source of the transistor (M) and the signal output end connects to the drain of the transistor (M), and
wherein the radio frequency amplifier further comprising an inductor (L) connected between the signal input end (Vᵢₙ) and the source of the transistor (M), and wherein as the capacitance value of the variable capacitor (Cₜᵤₙₑ) is adjusted, the magnetic flux passing through the first coil conductor (N1) is changed, and thus a current value passing through the second conductor (N2) is changed because of the coupling effect, and an output impedance (Rₒᵤₜ) of the transistor (M) is changed

2. The radio frequency amplifier of claim 1 **characterized in that** further comprising a pad capacitor (C_{pad}) connected to the signal input end (Vᵢₙ).

3. The radio frequency amplifier of claim 2 **characterized in that** further comprising a bypass capacitor (C_{bypass}) connected to the second coil conductor.

4. The radio frequency amplifier of claim 1 **characterized in that** further comprising a bypass capacitor (C_{bypass}) connected to the second coil conductor.

5. An integrated circuit comprising:
a signal process circuit (210); and
a radio frequency amplifier (100) according to claim 1 wherein an input end of the signal process circuit (210) connecting to the signal output end (Vₒᵤₜ) of the radio frequency amplifier (100),

6. The integrated circuit of claim 5, **characterized in that** the radio frequency amplifier (100) further including a pad capacitor (C_{pad}) connected to the signal input end (Vᵢₙ).

7. The integrated circuit of claim 6, **characterized in that** the radio frequency amplifier (100) further including a bypass capacitor (C_{bypass}) connected to the second coil conductor (N2).

8. The integrated circuit of claim 5, **characterized in that** the radio frequency amplifier (100) further including a bypass capacitor (C_{bypass}) connected to the second coil conductor (N2).

9. The integrated circuit of claim 5, **characterized in that** the radio frequency amplifier (100) being configured to be an input or output stage of the integrated circuit.

## Patentansprüche

1. Radiofrequenzverstärker, umfassend:
einen Transistor (M) aufweisend eine Quelle, eine Senke und einen Gatter;
einen Transformator aufweisend einen ersten Spulenleiter (N1) und einen zweiten Spulenleiter (N2), wobei der erste Spulenleiter (N1) mit dem zweiten Spulenleiter (N2) magnetisch gekoppelt ist; der zweite Spulenleiter (N2) mit dem Gatter des Transistors (M) direkt verbunden ist; der erste Spulenleiter (N1) mit der Quelle des Transistors (M) direkt verbunden ist;
einen variablen Kondensator (Cₜᵤₙₑ), der mit dem zweiten Spulenleiter (N2) parallel geschaltet, und mit dem Gatter des Transistors (M) verbunden ist;
ein Signaleingangsende (Vᵢₙ); und
ein Signalausgangsende (Vout),
wobei das Signaleingangsende (Vᵢₙ) mit der Quelle des Transistors (M) verbunden ist und das Signalausgangsende mit der Senke des Transistors (M) verbunden ist, und
wobei der Radiofrequenzverstärker ferner einen Induktor (L) umfasst, der zwischen dem Signaleingangsende (Vᵢₙ) und der Transistorquelle (M) geschaltet ist, und wobei, wenn der Kapazitätswert des variablen Kondensators (Cₜᵤₙₑ) eingestellt ist, der durch den ersten Spulenleiter (N1) fließende Magnetfluss geändert wird, und somit wird, aufgrund des Kopplungseffekts, ein durch den zweiten Spulenleiter (N2) fließende Stromwert geändert, und die Ausgangsimpedanz (Rₒᵤₜ) des Transistors (M) geändert.

2. Radiofrequenzverstärker nach Anspruch 1, **dadurch gekennzeichnet, dass** er ferner einen Pad-Kondensator (C_{pad}) umfasst, der mit dem Signaleingangsende (Vᵢₙ) verbunden ist.

3. Radiofrequenzverstärker nach Anspruch 2, **dadurch gekennzeichnet, dass** er ferner einen Bypass-Kondensator (C_{bypass}) umfasst, der mit dem zweiten Spulenleiter verbunden ist.

4. Radiofrequenzverstärker nach Anspruch 1, **dadurch gekennzeichnet, dass** er ferner einen Bypass-Kondensator (C_{bypass}) umfasst, der mit dem zweiten Spulenleiter verbunden ist.

5. Eine integrierte Schaltung, umfassend:
eine Signalprozessschaltung (210); und
einen Radiofrequenzverstärker (100) nach Anspruch 1, wobei ein Eingangsende der Signalprozessschaltung (210) mit dem Signalausgangsende (Vₒᵤₜ) des Radiofrequenzverstärkers (100) verbunden ist.

6. Integrierte Schaltung nach Anspruch 5, **dadurch gekennzeichnet, dass** der Radiofrequenzverstärker (100) ferner einen Pad-Kondensator (C_{pad}) umfasst, der mit dem Signaleingangsende (Vᵢₙ) verbunden ist.

7. Integrierte Schaltung nach Anspruch 6, **dadurch gekennzeichnet, dass** der Radiofrequenzverstärker (100) ferner einen Bypass-Kondensator (C_{bypass}) umfasst, der mit dem zweiten Spulenleiter (N2) verbunden ist.

8. Integrierte Schaltung nach Anspruch 5, **dadurch gekennzeichnet, dass** der Radiofrequenzverstärker (100) ferner einen Bypass-Kondensator (C_{bypass}) umfasst, der mit dem zweiten Spulenleiter (N2) verbunden ist.

9. Integrierte Schaltung nach Anspruch 5, **dadurch gekennzeichnet, dass** der Radiofrequenzverstärker (100) konfiguriert ist, eine Eingangs- oder Ausgangsstufe der integrierten Schaltung zu sein.

## Revendications

1. Amplificateur de radiofréquence comprenant :
un transistor (M) ayant une source, un drain et une grille ;
un transformateur ayant un premier conducteur à bobine (N1) et un deuxième conducteur à bobine (N2), le premier conducteur à bobine (N1) se couplant magnétiquement au deuxième conducteur à bobine (N2), le deuxième conducteur à bobine (N2) est directement relié à la grille du transistor (M), le premier conducteur à bobine (N1) est directement relié à la source du transistor (M);
un condensateur variable (Cₜᵤₙₑ) relié en parallèle au deuxième conducteur à bobine (N2), et relié à la grille du transistor (M) ;
une extrémité d'entrée de signal (Vᵢₙ) ; et
une extrémité de sortie de signal (Vout),
dans lequel l'extrémité d'entrée de signal (Vᵢₙ) est reliée à la source du transistor (M) et l'extrémité de sortie de signal est reliée au drain du transistor (M), et
dans lequel l'amplificateur de radiofréquence comprend en outre un inducteur (L) relié entre l'extrémité d'entrée de signal (Vᵢₙ) et la source du transistor (M), et dans lequel lorsque la valeur de capacitance du condensateur variable (Cₜᵤₙₑ) est réglée, le flux magnétique passant à travers le premier conducteur à bobine (N1) varie, et donc une valeur de courant passant à travers le deuxième conducteur (N2) varie à cause de l'effet de couplage, et une impédance de sortie (Rₒᵤₜ) du transistor (M) varie.

2. Amplificateur de radiofréquence de la revendication 1, **caractérisé en ce qu'**il comprend en outre un condensateur à pastille (C_{pad}) relié à l'extrémité d'entrée de signal (Vᵢₙ).

3. Amplificateur de radiofréquence de la revendication 2, **caractérisé en ce qu'**il comprend en outre un condensateur de découplage (C_{bypass}) relié au deuxième conducteur à bobine.

4. Amplificateur de radiofréquence de la revendication 1, **caractérisé en ce qu'**il comprend en outre un condensateur de découplage (C_{bypass}) relié au deuxième conducteur à bobine.

5. Circuit intégré comprenant :
un circuit de traitement de signal (210) ; et
un amplificateur de radiofréquence (100) selon la revendication 1 dans lequel une extrémité d'entrée du circuit de traitement de signal (210) est reliée à l'extrémité de sortie de signal (Vₒᵤₜ) de l'amplificateur de radiofréquence (100),

6. Circuit intégré de la revendication 5, **caractérisé en ce que** l'amplificateur de radiofréquence (100) comprend en outre un condensateur à pastille (C_{pad}) relié à l'extrémité d'entrée de signal (Vᵢₙ).

7. Circuit intégré de la revendication 6, **caractérisé en ce que** l'amplificateur de radiofréquence (100) comprend en outre un condensateur de découplage (C_{bypass}) relié au deuxième conducteur à bobine (N2).

8. Circuit intégré de la revendication 5, **caractérisé en ce que** l'amplificateur de radiofréquence (100) comprend en outre un condensateur de découplage (C_{bypass}) relié au deuxième conducteur à bobine (N2).

9. Circuit intégré de la revendication 5, **caractérisé en ce que** l'amplificateur de radiofréquence (100) est configuré pour être une étape d'entrée ou de sortie du circuit intégré.
